# EUROPÄISCHE PATENTSCHRIFT

(11) **EP 0 865 074 B1**
(45) Veröffentlichungstag und Bekanntmachung des Hinweises auf die Patenterteilung: **13.08.2008**
(21) Anmeldenummer: 98101176.0
(22) Anmeldetag: 23.01.1998
(51) Int. Cl.: H01L 21/28, H01L 21/3213

(54) **Verfahren zur Herstellung einer dotierten Polysiliciumschicht**
Process of making a doped polysilicon layer
Procédé de fabrication d'un couche en polysilicium dopé

(30) Priorität: 20.02.1997 DE 19706783
(43) Veröffentlichungstag der Anmeldung: 16.09.1998
(73) Patentinhaber: Infineon Technologies AG, 81669 München (DE)
(72) Erfinder: Dreybrodt, Jörg, 01127 Dresden (DE); Drescher, Dirk, Dr., 01465 Langebrück (DE); Zedlitz, Ralf, 01127 Dresden (DE); Wege, Stephan, 01474 Weissig (DE)
(74) Vertreter: Epping - Hermann - Fischer

(56) Entgegenhaltungen:
- EP-A- 0 466 166
- EP-A- 0 529 952
- EP-A- 0 772 231
- WO-A-96/27899
- CN-A- 1 135 656
- DE-A- 4 425 351
- US-A- 5 094 712
- US-A- 5 346 586
- ANONYMOUS: "Process for forming tungsten silicide with good adhesion to doped polycrystalline silicon" RESEARCH DISCLOSURE., Bd. 289, Nr. 28924, Mai 1988 (1988-05), Seite 279 XP002105557 HAVANT GB
- "METHOD FOR SUPPRESSING DIFFUSION OF DOPANT FROM DOPED POLYSILICON TO SILICIDE" IBM TECHNICAL DISCLOSURE BULLETIN, Bd. 32, Nr. 6A, 1. November 1989 (1989-11-01), Seite 206/207 XP000043178
- "INTEGRATED IN-SITU DOPED POLYSILICON/TUNGSTEN SILICIDE GATE CONDUCTOR" IBM TECHNICAL DISCLOSURE BULLETIN, Bd. 38, Nr. 6, 1. Juni 1995 (1995-06-01), Seite 115 XP000520600
- PATENT ABSTRACTS OF JAPAN vol. 016, no. 417 (E-1258), 3. September 1992 (1992-09-03) & JP 04 142737 A (SONY CORP), 15. Mai 1992 (1992-05-15)
- KOW-MING CHANG ET AL: "Highly selective etching for polysilicon and etch-induced damage to gate oxide with halogen-bearing electron-cyclotron-resonance plasma" JOURNAL OF APPLIED PHYSICS, 1 SEPT. 1996, AIP, USA, Bd. 80, Nr. 5, Seiten 3048-3055, XP002119036 ISSN: 0021-8979

## Beschreibung

Die Erfindung betrifft ein Verfahren zur Herstellung einer dotierten Polysiliciumschicht.

Insbesondere betrifft die Erfindung die Herstellung von Gateelektroden der Transistoren und der Wortleitungen in mikroelektronischen Bauelementen. Die hierfür üblicherweise eingesetzten Verfahren umfassen das aufeinanderfolgende Abscheiden von vier Schichten, nämlich Gateoxid (SiO₂), polykristallinem Silicium (kurz im allgemeinen als Polysilicium bezeichnet), Metall bzw. Metallsilicid und einer Isolationsschicht (z.B. SiO₂).

Um die erforderliche Leitfähigkeit sicherzustellen, wird die Polysiliciumschicht üblicherweise mit Dotieratomen in hohen Konzentrationen versetzt. Hierbei ist eine gleichmäßige Verteilung der Dotieratome über die Polysiliciumschicht sehr wichtig. Anderenfalls ist die Haftung von dotierter Polysiliciumschicht und angrenzender Metall(silicid)-Schicht nicht zufriedenstellend und das hochdotierte Polysilicium mit stark schwankendem Dotierniveau nur äußerst schwer strukturierbar.

Bei einem besonders häufig angewendeten Verfahren geht man im Falle der eingangs beschriebenen Schichtstruktur so vor, daß die Dotierung der Polysiliciumschicht erst nach der Strukturierung der Schichtstruktur durch einen Ätzvorgang erfolgt, indem die Dotieratome aus der benachbarten Metallsilicidschicht durch Temperung in das Polysilicium eingetrieben werden. Eine gleichmäßige Verteilung der Dotieratome ist so praktisch nicht erreichbar. Eine andere Möglichkeit besteht darin, die Dotierverbindung bei der chemischen Gasphasenabscheidung dem Prozeßgas zuzusetzen und die Dotieratome gemeinsam mit dem Silicium abzuscheiden. Hierdurch ist zwar eine gleichmäßigere Verteilung der Dotieratome erreichbar, die Oberflächenbeschaffenheit und Haftung zu benachbarten Schichten ist bei der herkömmlichen Durchführung dieses Verfahrens jedoch nicht optimal.

Die Haftprobleme zwischen den Schichten können teilweise durch zusätzliche Reinigungsschritte vor dem Aufbringen der Nachbarschicht behoben werden. Derartige Reinigungsschritte sind jedoch zeitaufwendig und verteuern die Herstellung der Halbleiterbauelemente. Die Beschaffenheit der Grenzschicht (z.B. Veränderungen durch Oxidation an Luft) spielt zudem für das elektrische Verhalten eine entscheidende Rolle.

Bei der Strukturierung der Schichten bereiten zum einen die unterschiedlichen Materialeigenschaften der einzelnen Schichten sowie zum anderen Konzentrationsschwankungen innerhalb einer Schicht Schwierigkeiten. Wünschenswerte wären gerade geätzte Flanken über alle Schichten bei einer möglichst geringen Schädigung des Gateoxids durch den Ätzprozeß über die gesamte Waferfläche, um eine hinreichende Qualität der mikroelektronischen Bauelemente sicherzustellen. Die bisher bekannten Verfahren erfüllen diese Anforderungen nicht in hinreichendem Maße. Zum einen müssen die Schichtdicken wegen der geringen Selektivität der bekannten Ätzverfahren relativ groß sein, um Unterätzungen der Schichten und eine Beschädigung des Gateoxids zu vermeiden. Sehr flache Schichtstrukturen sind deshalb kaum realisierbar. Auch die Homogenität des Ätzvorgangs über die zu ätzende Fläche und die Struktur der geätzten Flanken sind nicht völlig zufriedenstellend. Für eine präzise Strukturierung einer Schichtstruktur ist neben einer gleichmäßigen Qualität der einzelnen Schichten innerhalb der Struktur ein Strukturierungsverfahren nötig, das über mehrere Stufen verläuft, die auf die Materialeigenschaften der Schichtstruktur gezielt angepaßt sind.

Die Literaturstelle Anonymous: "Process for forming tungsten silicide with good adhesion to doped polycrystalline silicon" aus Research Disclosure, Band 289, Nr. 28924, Mai 1988 (1988-05), Seite 279, XP002105557 Havant GB, beschreibt die Abscheidung von Polysilicium mit einem CVD-Prozess. Am Ende der Polysiliciumabscheidung werden die Prozessparameter verändert, so dass sich eine reine Polysiliciumschicht ergibt. Anschließend wird mittels eines Standard-CVD-Prozesses Wolframsilizid abgeschieden. Spezielle Vakuumbedingungen sind nicht angegeben.

Aufgabe der Erfindung ist es, ein Verfahren zu schaffen zur Herstellung einer dotierten Schicht, die polykristallines Silicium aufweis, welches in einer chemischen Gasphasenabscheidung abgeschieden ist, wobei der Dotierstoff homogen über die gesamte abgeschiedene Fläche verteilt und die Oberflächenbeschaffenheit und Haftung gegenüber einer benachbarten Schicht möglichst gut ist. Das Verfahren sollte zudem unter Verwendung herkömmlicher Verfahrensschritte und Vorrichtungen einfach und kostengünstig durchführbar sein.

Eine weitere Aufgabe der Erfindung besteht darin, ein Verfahren anzugeben, durch das Schichtstrukturen, welche wenigstens eine Polysilicium- und insbesondere eine dotierte Polysiliciumschicht und eine Metall- oder Metallsilicidschicht umfassen, mit möglichst hoher Selektivität, großer Homogenität über die zu strukturierende Fläche und unter Ausbildung möglichst gerader geätzter Flanken über alle geätzten Schichten strukturiert werden können. Die Selektivität sollte groß genug sein, um eine Reduzierung der Dicke der Schichten in der Schichtstruktur zu erlauben und so die Herstellung flacher mikroelektronischer Bauelemente zu ermöglichen.

Die Lösung der Aufgabe wird mit dem Verfahren gemäß Anspruch 1 erreicht, das folgende Schritte umfasst: Abscheiden von dotiertem polykristallinem Silicium mittels einer chemischen Gasphasenabscheidung unter Vakuum, indem eine Dotierverbindung als Prozeßgas bei der chemischen Gasphasenabscheidung zugesetzt wird; Beenden der Zufuhr der Dotierverbindung zum Prozessgas nach dem Erreichen der gewünschten Dotierung und der gewünschten Abscheidedauer, so daß eine Schicht aus undotiertem Silicium als Grenzschicht der dotierten Siliciumschicht während der chemischen Gasphasenabscheidung unter Vakuum abgeschieden wird; anschließend Abscheiden einer weiteren Schicht aus Metall oder Metallsilicid auf der auf der dotierten Polysiliciumschicht befindlichen Silicium-Grenzschicht unter Verwendung einer chemischen Gasphasenabscheidung unter Vakuum; wobei das Vakuum zwischen der Abscheidung der dotierten Polysiliciumschicht und der Abscheidung der Metall- oder Metallsilicidschicht nicht aufgehoben wird.

Das Verfahren ermöglicht die Herstellung gleichmäßig dotierter Polysiliciumschichten, die sehr viel besser strukturiert werden können als auf herkömmliche Weise dotiertes Polysilicium, und deren Oberflächenbeschaffenheit und Haftfähigkeit gegenüber einer Nachbarschicht verbessert ist.

Vorteilhafte und bevorzugte Weiterbildungen der Verfahren ergeben sich aus den Unteransprüchen.

In einem Aspekt betrifft die Erfindung ein Verfahren zur Herstellung einer dotierten Schicht, die hauptsächlich aus polykristallinem Silicium besteht, welches durch chemische Gasphasenabscheidung (CVD = Chemical Vapour Deposition) abgeschieden ist. Eine derartige Schicht wird im folgenden zur Vereinfachung auch kurz als dotierte Polysiliciumschicht bezeichnet.

Das erfindungsgemäße Verfahren betrifft ebenfalls die Herstellung von Schichtstrukturen, welche eine derartige dotierte Polysiliciumschicht umfassen.

Erfindungsgemäß erfolgt die Dotierung, indem die Dotierverbindung während der chemischen Gasphasenabscheidung des polykristallinen Siliciums als Prozeßgas zugesetzt wird. Die Dotierung erfolgt also gleichzeitig mit der Abscheidung des polykristallinen Siliciums. Verglichen mit dem Implantationsverfahren entfallen gesonderte Schritte zur Reinigung des polykristallinen Siliciums vor der Implantation der Dotieratome und zur Implantation der Dotierstoffe selbst. Dadurch ist nicht nur eine erhebliche Verkürzung der Herstellungszeit, sondern auch eine Einsparung von Reinraumfläche möglich. Das erfindungsgemäße Verfahren ist somit äußerst kostengünstig. Es erfordert zudem keinerlei zusätzliche Dotierungsvorrichtungen. Durch die "in situ"-Dotierung können darüber hinaus das Defektdichteniveau und die Konzentration von Verunreinigungen stark reduziert werden, was hinsichtlich der weiteren Bearbeitung und auch im Hinblick auf die Zuverlässigkeit des fertigen mikroelektronischen Bauelements äußerst vorteilhaft ist.

Das erfindungsgemäße Verfahren wird so durchgeführt, daß gegen Ende des Verfahrens, d.h. nach Ablauf der gewünschten Abscheidedauer und Erreichen der gewünschten Konzentration an Dotieratomen, die Zufuhr der Dotierverbindung zum Prozeßgas beendet wird. Als Folge hiervon wird auf dem dotierten Polysilicium eine Grenzschicht aus undotiertem Polysilicium abgeschieden. Dies führt dazu, daß eine gegenüber dem dotierten Polysilicium deutlich bessere Oberflächenbeschaffenheit erhalten wird. Dies ist für Strukturierung der Schicht und die Haftfähigkeit gegenüber einer Nachbarschicht von Vorteil.

Die Schicht aus undotiertem Polysilicium verbessert jedoch nicht nur die Haftung der Nachbarschicht, sondern kann auch die Homogenität der Stöchiometrie in der Metallsilicidschicht erhöhen. Von besonderer Bedeutung ist dies im Grenzflächenbereich stark metalldotierter Polysiliciumschichten. Beispielsweise ist im Falle von Wolframsilicidschichten mit starker Wolframanreicherung beobachtet worden, daß es bei nachfolgenden Hochtemperatur-Bearbeitungsschritten zu einem Stöchiometrieausgleich kommt. Siliciumatome wandern aus Nachbarbereichen in die stark mit Wolfram angereicherten Bereiche und lassen so im Nachbarbereich Mikrolöcher entstehen.
Die Aufbringung einer "sauberen", d.h. undotierten, Polysiliciumschicht verhindert das Auftreten dieses Phänomens im Grenzflächenbereich und sorgt so für eine gute Stöchiometriehomogenität über die gesamte Schichtdicke der Metallsilicidschicht.

Abscheidung von Haftvermittlerschichten aus undotiertem Polysilicium und die Erzeugung der dotierten Polysiliciumschicht können erfindungsgemäß also in einem Verfahrensdurchgang durch geeignete Einstellung der Konzentration der Dotierverbindung im Prozeßgas erreicht werden.

Ein Beispiel für ein solches Verfahren ist in einem späteren Abschnitt der Anmeldung angegeben, wo auch die Vorteile der Erfindung unter Bezugnahme auf einige Figuren näher erläutert sind.

Als Dotieratome können grundsätzlich alle zur Dotierung polykristallinen Siliciums gebräuchlichen Atome vom p- und n-Typ angesprochen werden, wie Bor, Gallium, Indium, Phosphor, Arsen und Antimon. Da die Dotieratome in Form ihrer Verbindungen als Prozeßgas der chemischen Gasphasenabscheidung des Polysiliciums zugeführt werden, werden zweckmäßig solche Verbindungen eingesetzt, die gasförmig oder leichtflüchtig sind. Beispielhaft können Diboran (B₂H₆), Trimethylbor (B(CH₃)₃), Phosphan (PH₃) oder Arsan (AsH₃) genannt werden.
Die Dotierverbindungen zersetzen sich unter den Prozeßbedingungen, und die Dotieratome scheiden sich gemeinsam mit dem Silicium ab und werden in die Polysiliciumschicht eingelagert.

Die Dotierverbindung kann dem Gasstrom von Beginn an in einem über die gesamte Gasphasenabscheidung hin konstanten Anteil zugesetzt werden, der dem gewünschten Mengenverhältnis der Dotieratome in der Polysiliciumschicht entsprechend gewählt wird.

Außerdem ist es möglich, das Verhältnis von Dotierverbindung und Si-haltiger Verbindung zueinander konstant zu halten, ihren Anteil im Gas im Verlauf der Abscheidung jedoch kontinuierlich oder stufenweise zu erhöhen.

Um eine gute Dickenhomogenität der abgeschiedenen Schicht über die Waferfläche zu erhalten, kann es vorteilhaft sein, die Dotierung mit einem Konzentrationsgradienten durchzuführen. Zweckmäßig wird die Konzentration der Dotierverbindung, bezogen auf die Gesamtmenge der zugeführten, abzuscheidenden Verbindungen, im Verlauf des Abscheideverfahrens gesteigert.

Vorteilhaft wird zunächst mit der Abscheidung reinen Siliciums begonnen, da dann die Haftung auf dem Untergrund in der Regel besser ist, und anschließend wird die Dotierverbindung zugeführt und deren Konzentration kontinuierlich oder schrittweise erhöht, bis die gewünschte Konzentration an Dotieratomen im Polysilicium erreicht ist.

Andererseits ist es auch möglich, die Dotierverbindung zunächst in der der gewünschten Endkonzentration der Dotieratome im Silicium entsprechenden Menge zuzusetzen und mit zunehmender Dauer der Gasphasenabscheidung den Anteil der siliciumhaltigen Verbindung im Gasstrom zu erhöhen.

Das erfindungsgemäße Verfahren kann zur Abscheidung dotierter Polysiliciumschichten auf verschiedensten Substraten eingesetzt werden. Besonders geeignet ist das erfindungsgemäße Verfahren zur Herstellung von Gateelektroden der Transistoren und Wortleitungen eines Halbleiterbauelements.

Hierbei wird die dotierte Polysiliciumschicht beispielsweise auf die oben beschriebene Weise auf der Gateoxidschicht, die üblicherweise aus Siliciumdioxid besteht, abgeschieden. Anschließend kann auf die dotierte Polysiliciumschicht mit der Grenzschicht aus reinem Polysilicium eine Schicht aus Metall oder Metallsilicid aufgebracht werden. Das Metallsilicid wird zweckmäßig ebenfalls durch chemische Gasphasenabscheidung aufgebracht. Dabei kann vorteilhaft dieselbe Vorrichtung verwendet werden, die zur Deposition der Polysiliciumschicht benutzt wurde, zweckmäßig jedoch eine andere Depositionskammer als bei der Abscheidung des Polysiliciums. Auf diese Weise ist die Herstellung der Gateelektroden und Wortleitungen besonders einfach und ökonomisch durchführbar. Als Metallsilicid eignen sich alle üblicherweise bei mikroelektronischen Bauelementen eingesetzten Verbindungen und insbesondere die Silicide des Cobalts, Titans, Tantals, Molybdäns und Wolframs.

Auf die Metallsilicidschicht kann anschließend noch eine Isolationsschicht aufgebracht werden. Hier eignen sich alle üblicherweise in mikroelektronischen Bauteilen verwendeten Isolationsschichten. Besonders geeignet sind solche aus Siliciumdioxid und Siliciumnitrid und hier insbesondere sogenannte TEOS- oder cap-TEOS-Schichten, die durch Gasphasenabscheidung von Tetraethoxysilan erzeugt werden.

Besonders gute Ergebnisse hinsichtlich der Qualität der Schichten innerhalb der Schichtstruktur können erzielt werden, wenn einer oder mehrere der Beschichtungsschritte und insbesondere die Aufbringung der dotierten Polysiliciumschicht im Vakuum oder Hochvakuum durchgeführt werden. Vorteilhaft ist es insbesondere, wenn beim Transfer des Wafers von einer Kammer der CVD-Vorrichtung in die nächste das Vakuum bestehen bleibt. Beispielsweise wird also zweckmäßig das Vakuum zwischen der Kammer für die Polysilicium-Abscheidung und derjenigen für die Metallsilicid-Abscheidung nicht unterbrochen.

Wird auf die Schichtstruktur eine Schicht aus Siliciumdioxid oder Siliciumnitrid als Isolationsschicht aufgebracht, kann diese im Strukturierungsverfahren als Maske bei der Ätzung der darunterliegenden Schichten dienen.

Ein Verfahren zum Strukturieren einer Schichtstruktur, die wenigstens eine Metall- oder Metallsilicidschicht auf einer Schicht aus polykristallinem Silicium umfasst, ist in dieser Anmeldung beschrieben. Es ist jedoch nicht Gegenstand der vorliegenden Erfindung gemäß den beigefügten Patentansprüchen.

Wie bereits erwähnt, bereitet die Strukturierung derartiger Schichtstrukturen große Schwierigkeiten. Dies gilt besonders dann, wenn es sich bei der Polysiliciumschicht um eine dotierte Schicht und insbesondere um eine Schicht mit Dotiergradienten handelt. Es war bisher praktisch nicht möglich, derartige Schichtstrukturen selektiv und unter Ausbildung gerader Ätzflanken zu strukturieren. Das Verfahren schafft hier Abhilfe.

Der Ätzvorgang erfolgt in wenigstens drei Stufen, von denen die erste Stufe eine fluorhaltiges Ätzgas, die zweiten ein chlorhaltiges und die dritte ein bromhaltiges Gas verwendet.

Im Stand der Technik waren bisher zweistufige Ätzverfahren für die oben genannten Schichtstrukturen üblich.

Durch die geeignete Wahl der Ätzmittel und ihre Abstimmung auf die zu strukturierenden Schichten gelingt ein äußerst selektives Ätzen der einzelnen Schichten, bei dem Über- und Unterätzungen weitgehend vermieden werden können.

Die Steuerung des Ätzvorgangs kann entweder durch Wahl einer geeigneten festen Ätzdauer oder durch Endpunktbestimmung erfolgen. Zur Endpunktsteuerung einer oder mehrerer der Ätzstufen eignet sich insbesondere ein spektroskopisches Verfahren. Besonders geeignet ist die optische Emissionsspektroskopie (OES), bei welcher die über dessen Emission bestimmte Konzentration eines Ätzmittels oder Ätzproduktes Aufschluß über den Verlauf des Ätzvorgangs gibt. Auf diese Weise kann der Endpunkt der einzelnen Ätzschritte sehr genau bestimmt werden, und es wird eine genaue Kontrolle der jeweiligen Ätzprozesse gewährleistet.

Darüber hinaus kann mit einem spektroskopischen Verfahren auch die Restschichtdicke der zu ätzenden Schicht festgestellt werden.

In der ersten Stufe, die auch als "Breakthrough" bezeichnet werden kann, wird mit dem fluorhaltigen Ätzgas ein Großteil der Metall- oder Metallsilicidschicht weggeätzt. Es bleibt nur ein Rest der Schicht, beispielsweise ca. 25 % der ursprünglichen Schichtdicke erhalten. In der anschließenden zweiten Stufe - dem Hauptätzschritt "Mainetch" - wird mit chlorhaltigem Ätzgas die restliche Metall- oder Metallsilicidschicht sowie ein Großteil der darunterliegenden Polysiliciumschicht weggeätzt. Die zweite Stufe wird bevorzugt so durchgeführt, daß ein geringer Rest der Polysiliciumschicht erhalten bleibt, beispielsweise mit einer Schichtdicke von ca. 50 nm. Die Bestimmung der Restschichtdicke des Polysiliciums erfolgt bevorzugt durch OES. Der Rest Polysilicium wird in der dritten Stufe, dem sogenannten "Overetch", selektiv weggeätzt. Hierzu wird bromhaltiges Ätzgas verwendet. Die Verwendung des bromhaltigen Ätzgases gewährleistet eine hohe Selektivität in diesem Verfahrensschritt und verhindert weitgehend, daß die unter der Polysiliciumschicht liegenden Schichten angegriffen werden. Darüber hinaus hat die bromhaltige Chemie im Overetch den Vorteil, daß das Metallsilicid nicht unterätzt werden kann. Damit sind quasi beliebig lange Überätzzeiten möglich. Dies ist von großer Wichtigkeit bei Verkleinerung der Transistordimensionen und größerer Topografie des Untergrundes. Besonders geeignet ist dieses Verfahren, wenn sich unter der Polysiliciumschicht eine Gateoxidschicht aus Siliciumdioxid befindet. Das erfindungsgemäße Verfahren kann also von Vorteil auf Schichtstrukturen angewendet werden, die Schichten in der Reihenfolge Gateoxid, Polysilicium, Metall- oder Metallsilicid und Isolationsschicht umfassen.

Das Verfahren eignet sich für Schichtstrukturen mit einer Polysiliciumschicht, die dotiert oder undotiert sein kann. Besonders gute Ergebnisse werden erzielt, wenn im Fall einer dotierten Polysiliciumschicht die Dotierung gemäß dem eingangs beschriebenen Dotierverfahren erfolgte. Die nach dem vorstehend erläuterten Verfahren hergestellten Schichtstrukturen eignen sich besonders gut zur Strukturierung nach dem Strukturierungsverfahren. Wegen der großen Selektivität des Strukturierungsverfahrens und der ausgezeichneten Homogenität über die gesamte Fläche der zu strukturierenden Schichten ist es möglich, die Dicke der einzelnen Schichten in der Schichtstruktur zu reduzieren, ohne daß es zu Überätzungen der jeweiligen Schichten kommt. Besonders gut gelingt dies durch Endpunktsteuerung des Ätzvorgangs mittels spektroskopischer Verfahren und insbesondere mittels OES. Das Vermeiden von Überätzungen betrifft nicht nur die zu strukturierenden Schichten, sondern auch die darunterliegenden Schichten, also beispielsweise die Gateoxidschicht. Dies bedeutet, daß die Gesamtdicke der Schichtstruktur deutlich verringert werden kann. Einerseits gestattet dies die Herstellung flacherer mikroelektronischer Bauelemente und andererseits ist es möglich, über der geätzten Schichtstruktur weitere Schichten wie Metallisierungsebenen oder ähnliches anzuordnen, ohne die zulässige. Gesamtbauhöhe eines mikroelektronischen Bauelements zu überschreiten.

Die Strukturierung der Schichtstruktur, welche wenigstens einer Metall- oder Metallsilicidschicht auf einer PolysiliciumSchicht umfaßt, kann grundsätzlich unter Verwendung der üblicher Weise beim Strukturieren eingesetzten Masken erfolgen. Beispielsweise können die üblichen Lackmasken aus Fotoresist oder ähnlichem verwendet werden. Bevorzugt erfolgt die Strukturierung jedoch unter Einsatz einer Hartmaske, die auf die Metall- oder Metallsilicidschicht aufgebracht wird. Besonders bevorzugt wird als Hartmaske eine Maske aus Siliciumdioxid oder Siliciumnitrid verwendet. Bei der Siliciumdioxidschicht kann es sich um sogenanntes (Cap)-TEOS handeln, also Siliciumdioxid, das durch ein CVD-Verfahren aus Tetraethoxysilan erzeugt wurde. Vorzugsweise wird diese Maske aus der Isolationsschicht hergestellt, die als oberste Schicht der Schichtstruktur auf der Metall- oder Metallsilicidschicht aufgebracht wurde. Durch die Verwendung einer solchen Hartmaske, die relativ dünn sein kann, läßt sich die Gesamthöhe der Schichtstruktur weiter verringern.

Die Strukturierung der Isolationsschicht erfolgt auf übliche Weise. Beispielsweise wird zunächst eine strukturierte Lackmaske auf die Isolationsschicht aufgetragen. Dann erfolgt das Öffnen der Schicht mit einem geeigneten Ätzmittel. Im Falle von Schichten aus Siliciumdioxid oder Siliciumnitrid kann das z.B. durch Plasmaätzen mit Argon, Trifluormethan und Sauerstoff erfolgen. Zweckmäßig erfolgt die Strukturierung der Hartmaske in einer anderen Kammer der Ätzvorrichtung als das nachfolgende drei- oder mehrstufige Ätzverfahren.

Die wenigstens drei Stufen des Ätzverfahrens für die unter der Hartmaske liegenden Schichten werden vorzugsweise in ein und derselben Kammer der Ätzvorrichtung durchgeführt. Als Ätzvorrichtung eignen sich alle üblicherweise zu diesem Zweck verwendeten Vorrichtungen.

Das im ersten Ätzschritt eingesetzte Ätzgas umfaßt wenigstens eine fluorhaltige Verbindung. Bevorzugte fluorhaltige Ätzgase umfassen NF₃, SF₆, SiF₄ oder deren Mischungen. Auch fluorierte Kohlenwasserstoffe wie CF₄, CHF₃ und ähnliche können allein oder im Gemisch mit einem oder mehreren der vorstehend genannten Fluoride verwendet werden. Eine bevorzugt eingesetzte Ätzgasmischung besteht aus NF₃, HCl, Cl₂, He und O₂.

In der zweiten Ätzstufe wird ein chlorhaltiges Ätzgas eingesetzt, das beispielsweise eine oder mehrere der Verbindung HCl, Cl₂ und BCl₃ umfassen kann. Ein bevorzugtes Ätzgas ist aus HCl, Cl₂, He und O₂ zusammengesetzt.

Als Ätzgas der dritten Stufe wird ein bromhaltiges Gas verwendet. Als Bromverbindung dient z.B. Bromwasserstoff. Geeignet ist ein Ätzgas, das aus HBr, He und O₂ besteht.

Durch das Strukturierungsverfahren kann die Polysiliciumschicht in den Bereichen, die nicht von der Maske geschützt sind, praktisch rückstandsfrei entfernt werden, ohne daß es zur Beschädigung der darunterliegenden Schichten, also beispielsweise der Gateoxidschicht, kommt. Eventuell noch vorhandene Spuren von Verunreinigungen oder Ätzrückständen können gegebenenfalls durch einen an die Ätzstufen anschließenden naßchemischen Reinigungsschritt entfernt werden. Geeignet ist hierfür beispielsweise eine verdünnte wäßrige Lösung von Fluorwasserstoff, z.B. im Verhältnis HF zu H₂O = 1:100 bis 200.

Mit dem Strukturierungsverfahren wird eine gegenüber dem bekannten Verfahren verbesserte Homogenität und Selektivität beim Ätzen der einzelnen Schichten in der Schichtstruktur erreicht. Das Ätzen der Schichtstruktur erfolgt praktisch frei von Rückständen und ohne Beschädigung benachbarter Schichten. Die ausgezeichnete Selektivität erlaubt es, die Schichten der Schichtstruktur dünner als bisher möglich auszugestalten und damit die Bauhöhe mikroelektronischer Bauteile zu vermindern. Das Ätzverfahren benötigt zudem einen gegenüber den Verfahren des Standes der Technik verringerten Gesamtätzzeitraum.

Außerdem werden gerade geätzte Flanken erhalten. Besonders vorteilhaft kann dies erreicht werden, wenn der zu strukturierende Wafer nicht mechanisch sondern elektrostatisch in der Ätzvorrichtung gehalten wird. Üblicherweise wird ein Wafer in der Ätzkammer befestigt, indem er mechanisch eingespannt und auf eine Dichtung gedrückt wird, die in einem bestimmten Abstand zur Kathode der Ätzkammer angeordnet ist. Zwischen Wafer und Kathode wird der Wärmekontakt mit einem Gas, beispielsweise Helium, unter Druck (z.B. 8 Torr wobei durch aus die Beschreibung mit 1Torr = 133Pa umgerechnet werden muss) hergestellt. Auf diese Weise ist der Wafer jedoch nur am Rand fixiert und kann sich im Innenbereich durchbiegen, so daß zwischen Waferrand und Kathode und zwischen Waferinnerem und Kathode unterschiedliche Abstände vorliegen. Dies führt zu ungleichmäßigen Ätzresultaten, da der Wärmetransport neben dem Heliumdruck vom Abstand Wafer - Kathode abhängt. Der Wafer wird daher elektrostatisch durch Einstellung einer bestimmten Spannung, die in der Regel zwischen 1000 und 1500 V liegt, festgehalten. Durch in der Kathode ausgebildete Kanäle wird ein Gas, im allgemeinen Helium, hindurchgeleitet, so daß zwischen Kathode und Wafer eine Art Gaskissen entsteht. Diese Art der elektrostatischen Halterung des Wafers wird nachfolgend als Electrostatic Chuck bezeichnet. Der Electrostatic Chuck bewirkt, daß über die gesamte Waferfläche gerade Flanken geätzt werden. Wichtig dabei ist, daß über den gesamten Wafer eine gleichmäßige Temperaturverteilung hergestellt wird. Darüber hinaus gibt es keine störenden Einflüsse der früher gebräuchlichen Clamp-Vorrichtung auf das Plasma in unmittelbarer Nähe des Waferrandes. Außerdem ist somit eine Reduktion der Partikeldichte zu erzielen.

In den Zeichnungen zeigen:
- Fig. 1: ein Konzentrationsprofil, das die Verteilung von Sauerstoff und Kohlenstoff in Schichtstrukturen zeigt, die unter Verwendung des erfindungsgemäßen Verfahrens und eines herkömmlichen Verfahrens hergestellt wurden;
- Fig. 2: Transmissions-Elektronenmikroskop-Aufnahmen einer Schichtstruktur mit und ohne Polysiliciümhaftschicht;
- Fig. 3: Abbildungen von strukturierten Wortleitungen, die unter Verwendung des Strukturierungsverfahrens hergestellt wurden, im Bereich der Wafermitte und des Waferrandes im Vergleich zu entsprechenden Wortleitungen, die unter Verwendung eines herkömmlichen Ätzverfahrens hergestellt wurden;
- Fig. 4: eine Abbildung strukturierter Wortleitungen, die unter Verwendung des Strukturierungsverfahrens hergestellt wurden;
- Fig. 5: verdeutlicht im Vergleich die Dicke des Gateoxids nach dem Ätzen gemäß dem Strukturierungsverfahren und einem herkömmlichen Verfahren sowie die zugehörigen Standardabweichungen, und
- Fig. 6 und 7: verdeutlichen die Endpunktbestimmung im Ätzverfahren mittels optischer Emissionsspektroskopie.

### Beispiel 1

### a) Herstellung einer P-dotierten polykristallinenSiliciumschicht

Auf einer Gateoxidschicht (SiO₂) eines Wafers wird durch chemische Gasphasenabscheidung (CVD) eine Schicht aus mit Phosphor dotiertem polykristallinem Polysilicium (Poly-Si) abgeschieden. Als Ausgangsverbindung für das polykristalline Silicium dient Silan (SiH₄). Für die Dotierung wird dem Prozeßgas Phosphan (PH₃) zugesetzt. Um eine gute Homogenität der Dotierung über den gesamten Wafer zu erreichen, erfolgt die Zugabe nach einem Konzentrationsgradienten, beginnend mit 10 % PH₃, bezogen auf die Endkonzentration des Phosphans, und auf 100 % ansteigend, alternierend in Schrittlängen von 2 und 3 Sekunden. Anschließend wird die Abscheidung fortgesetzt, bis die gewünschte Schichtdicke erreicht ist. Nach Erreichen der gewünschten Schichtdicke wird der Zusatz von Phosphan im Prozeßgas gestoppt, so daß sich auf dem dotierten Polysilicium eine Schicht undotierten Polysiliciums abscheidet, die die Haftung der nachfolgend aufgebrachten Wolframsilicidschicht verbessert.

Die gesamte Schichtdicke von dotiertem und undotiertem Polysilicium beträgt etwa 200 nm. Die Prozeßparameter sind in Tabelle 1 angegeben. "Abscheidungszeit dotiert" entspricht der Abscheidungszeit für die dotierte Polysiliciumschicht, "Abscheidungszeit undotiert" derjenigen für die Abscheidung undotierten Polysiliciums auf der dotierten Schicht.

### b) Herstellung einer Wolframsilicidschicht auf der Polysiliciumschicht

Der gemäß Beispiel 1a) beschichtete Wafer wird in eine andere Kammer derselben CVD-Vorrichtung überführt, ohne daß das Vakuum in der CVD-Vorrichtung aufgehoben wird. Vor Beginn einer Beschichtungsreihe wird diese Kammer in einem sogenannte Precoat-Verfahren ohne Wafer konditioniert, indem neben den Prozeßgasen Wolframhexafluorid und Dichlorsilan auch Silan zugeführt wird. Das Silan führt hierbei vermutlich zur Bildung katalytischer Spezies, die die Reaktion von WF₆ und SiH₂Cl₂ fördern. Die Zufuhr des ersten Wafers in die konditionierte Kammer sollte nicht später als 10 Minuten nach der Konditionierung erfolgen.

Die Bedingungen für die Abscheidung der Wolframsilicidschicht sind in Tabelle 1 zusammengestellt. Die Dicke der abgeschiedenen Wolframsilicidschicht beträgt etwa 170 nm.

**Tabelle 1**

| Arbeitsschritt | Parameter | Wert | Einheit |
|---|---|---|---|
| Target | Dicke Poly-Si | 200 +/- 20 | nm |
| Target | Schichtwiderstand | 100 +/- 40 | Ohm/Sq |
| Target | Schichtbeanspruchung | < 300 | MPa |
| Poly-Si-Abscheidung | Druck | 80 | Torr |
| | Temperatur | 660 | °C |
| | Abscheidungszeit dotiert | 22 + 85 | Sec |
| | Abscheidungszeit undotiert | 18 | Sec |
| | H₂-Fluß, Haupt- | 4,9 | slm |
| | H₂-Fluß, Schlitzventil | 4,6 | slm |
| | SiH₄-Fluß | 0,5 | slm |
| | PH₃-Fluß | 45 | sccm |
| Target | Dicke WSiₓ | 170 +/- 25 | nm |
| Target | Schichtwiderstand | 45 +/- 6,5 | Ohm/Sq |
| Target | Schichtbeanspruchung | < 1300 | MPa |
| WSiₓ-Abscheidung | Druck | 1 | Torr |
| | Temperatur | 550 | °C |
| | Nukleationszeit | 20 | Sec |
| | Abscheidungszeit | 90 | Sec |
| | Zeit SiH₄ | 10 | Sec |
| | WF₆-Fluß | 3,5 | sccm |
| | Ar-Fluß, Kopf | 0,85 | slm |
| | Ar-Fluß, Boden | 700 | sccm |

Nach Durchführung der Verfahrensschritte a) und b) wird ein Wafer erhalten, auf dessen Gateoxidschicht zunächst eine Schicht aus P-dotiertem Polysilicium mit einer Grenzschicht aus undotiertem Polysilicium und anschließend eine Schicht aus Wolframsilicid abgeschieden sind.

Beide Beschichtungsschritte können unmittelbar aufeinanderfolgend in einer CVD-Anlage durchgeführt werden, wodurch die Herstellung sehr einfach, schnell und kostengünstig möglich ist. Das erfindungsgemäße Verfahren führt zudem zu Schichten von hervorragender Homogenität mit einem äußerst geringen Anteil an Verunreinigungen.

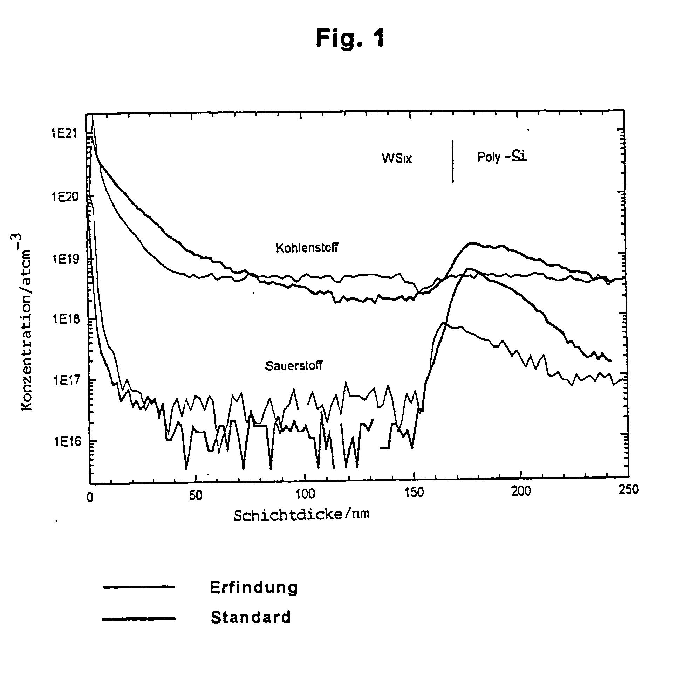

Dies ist Fig. 1 zu entnehmen. Hier sind SIMS-Spektren (SIMS = Secundary Ion Mass Spectroscopie; Sekundärionen-Massenspektroskopie) gezeigt, die die Konzentrationsprofile von Kohlenstoff und Sauerstoff im Grenzbereich zwischen Polysilicium-und Wolframsilicidschicht wiedergeben. Die Konzentration ist auf der y-Achse aufgetragen, während die x-Achse der Schichtdicke entspricht. Eine Dicke von 0 nm entspricht der äußeren Oberfläche der Wolframsilicidschicht. Mit steigender Schichtdicke und höherer Eindringtiefe in die Schichtstruktur nähert man sich der Polysiliciumschicht. Die Grenzfläche zwischen beiden Schichten liegt im Bereich von 170 nm.

Die dünnen Linien geben die Situation in einem Wafer wieder, der gemäß dem erfindungsgemäßen Verfahren beschichtet wurde, während die dicken Linien der Situation in einem nach einem herkömmlichen Verfahren beschichteten und dotierten Wafers entsprechen.

Fig. 1 zeigt, daß sowohl die Sauerstoff- als auch die Kohlenstoffkonzentration, die im Grenzbereich zwischen Polysilicium- und Wolframsilicidschicht gefunden werden, im Falle der herkömmlich hergestellten Wafer um ca. eine Zehnerpotenz größer sind als bei den erfindungsgemäß beschichten Wafern. Das erfindungsgemäße Verfahren ermöglicht also eine drastische Reduzierung von Verunreinigungen im Grenzbereich zwischen Polysilicium und Wolframsilicid.

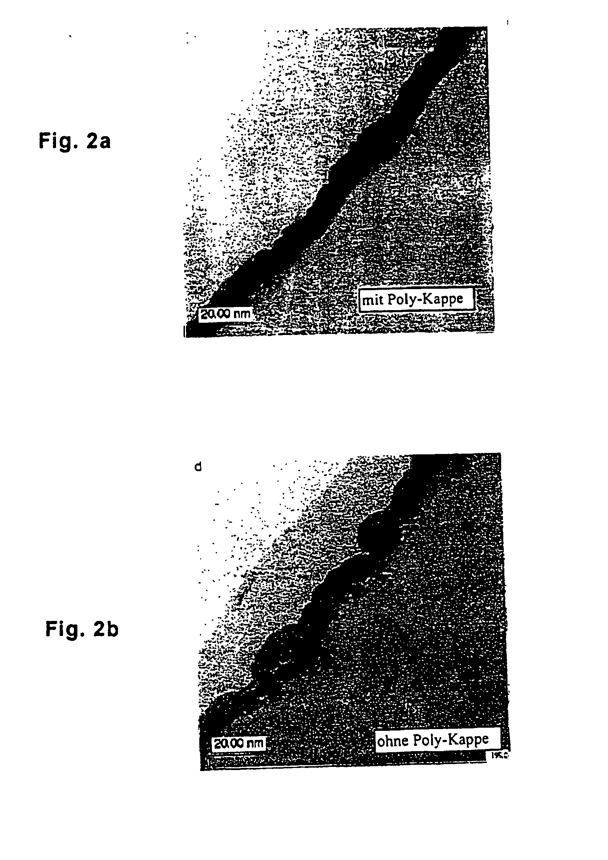

Fig. 2 verdeutlicht die Vorteile, die dadurch erhalten werden können, daß bei dem erfindungsgemäßen Verfahren zwischen dotierter Polysiliciumschicht und Metallsilicidschicht eine Grenzschicht aus undotiertem Polysilicium abgeschieden wird. Die Transmissions-Elektronenmikroskop-Aufnahmen zeigen eine durch CVD erzeugte Schichtstruktur aus Polysilicium und Metallsilicid. Die Metallsilicid-Nukleationsschicht (WSiₓ) ist die dunkle Schicht. In Fig. 2a ist auf das dotierte Polysilicium eine ca. 30 nm dicke Schicht aus undotiertem Polysilicium abgeschieden worden. Die Nukleation ist hier sehr homogen erfolgt. Dagegen zeigt Fig. 2b, bei der eine Kappe aus undotiertem Polysilicium fehlt, Mikrolöcher im Bereich zwischen Polysilicium und Wolframsilicid. Die Nukleation des Wolframsilicids auf dem dotiertem Polysilicium ist hier behindert.

Mit dem erfindungsgemäßen Verfahren lassen sich auf einfache, effektive und kostengünstige Weise Schichtstrukturen herstellen, deren Schichten eine ausgezeichnete Homogenität aufweisen und deren Gehalt an Verunreinigungen äußerst gering ist. Zudem ist es möglich, dotierte Polysiliciumschichten herzustellen, mit einer gleichmäßigen Verteilung der Dotieratome über die gesamte abgeschiedene Fläche. Die Haftung zusätzlicher Schichten auf der dotierten Polysiliciumschicht ist gut, da eine undotierte Polysilicium-Grenzschicht aufgebracht ist. Gesonderte Reinigungs- und Implantierungsschritte sind nicht erforderlich. Die gleichmäßige Verteilung der Dotieratome und die große Homogenität der Schichten in der erfindungsgemäß hergestellten Schichtstruktur ermöglichen zudem eine exakte Strukturierung dieser Schichten. Besonders vorteilhafte Ergebnisse lassen sich erzielen, wenn die Strukturierung der Schichtstrukturen durch das nachfolgend erläuterte Strukturierungsverfahren erfolgt.

### Beispiel 2

Strukturierung einer Schichtstruktur, welche eine Wolframsilicidschicht und eine dotierte Polysiliciumschicht umfaßt

Das nachfolgend beschriebene Strukturierungsverfahren ist nicht Gegenstand der in den Patentansprüchen beanspruchten Erfindung.

Die gemäß Beispiel 1 hergestellte Schichtstruktur, bei welcher eine P-dotierte Polysiliciumschicht und eine Wolframsilicidschicht auf eine Gateoxidschicht abgeschieden wurden, wird nach Aufbringen einer Hartmaske durch Plasmaätzen strukturiert. Die Hartmaske besteht aus einer Siliciumdioxidschicht, die auf übliche Weise durch Abscheiden von Tetraethoxysilan erzeugt und nach Aufbringen einer Lackmaske mit Argon, Trifluormethan und Sauerstoff strukturiert wurde. Die Maske besitzt die Struktur verschachtelter Linien mit einer Breite von 0,46 +/- 0,07 µm.

Die Dicke der Wolframsilicidschicht beträgt 170 nm, die der Polysiliciumschicht 200 nm. Das Ätzverfahren für die Wolframsilicid- und Polysiliciumschichten erfolgt in einer anderen Kammer derselben Plasmaätzvorrichtung, die zur Strukturierung der Hartmaske verwendet wurde.

In der ersten Ätzstufe (Breakthrough) wird ein Ätzgas aus NF₃, HCl, Cl₂ und He/O₂ verwendet. Einzelheiten des Ätzverfahrens sind der nachfolgenden Tabelle 2 zu entnehmen.

Die erste Stufe wird so lange durchgeführt, bis ca. 75 % der Wolframsilicidschicht entfernt sind. In der zweiten Stufe (Mainetch) wird der Rest der Wolframsilicidschicht und die Polysiliciumschicht bis auf einen Rest von ca. 50 nm Dicke entfernt. Der Endpunkt des Ätzschrittes wird zweckmäßig mittels OES bestimmt (vergleiche Beispiel 3a). Als Ätzgas dient HCl, Cl₂ und He/O₂. Anschließend wird der Rest der Polysiliciumschicht mit HBr, He/O₂ weggeätzt. Dieser als Overetch bezeichnete Schritt ist sehr selektiv und erfolgt praktisch ohne Schädigung des unter der Polysiliciumschicht liegenden Gateoxids.

Die Ätzkammer wird vor dem Einführen des nächsten zu strukturierenden Wafers mit einem Silicium-Dummy gereinigt. Der strukturierte Wafer wird im Anschluß an das Ätzverfahren durch Eintauchen in eine verdünnte wäßrige HF-Lösung für 60 Sekunden gereinigt.

**Tabelle 2**

| Arbeitsschritt | Parameter | Wert | Einheit |
|---|---|---|---|
| Breakthrough (Durchbruch) | Druck | 20 | Torr |
| | Leistung | 500 | Watt |
| | HCl-Fluß | 15 | sccm |
| | Cl₂-Fluß | 90 | sccm |
| | NF₃-Fluß | 15 | sccm |
| | He/O₂-Fluß | 15 | sccm |
| | He; Rückseite | 9,5 | Torr |
| | Zeit | 20 | Sec |
| | B-Feld | 20 | Gauss |
| Mainetch (Hauptätzen) | Druck | 20 | mTorr |
| | Leistung | 500 | Watt |
| | HCl-Fluß | 18 | sccm |
| | Cl₂-Fluß | 110 | sccm |
| | He/O₂-Fluß | 10 | sccm |
| | He; Rückseite | 9,5 | Torr |
| | Zeit | 35 | Sec |
| | B-Feld | 20 | Gauss |
| Overetch (Überätzen) | Druck | 50 | mTorr |
| | Leistung | 175 | Watt |
| | HBr-Fluß | 80 | sccm |
| | He/O₂-Fluß | 8 | sccm |
| | He; Rückseite | 9,5 | Torr |
| | Zeit | 140 | Sec |

Die vorteilhaften Ergebnisse des Strukturierungsverfahrens sind anhand der nachfolgenden Figuren erläutert.

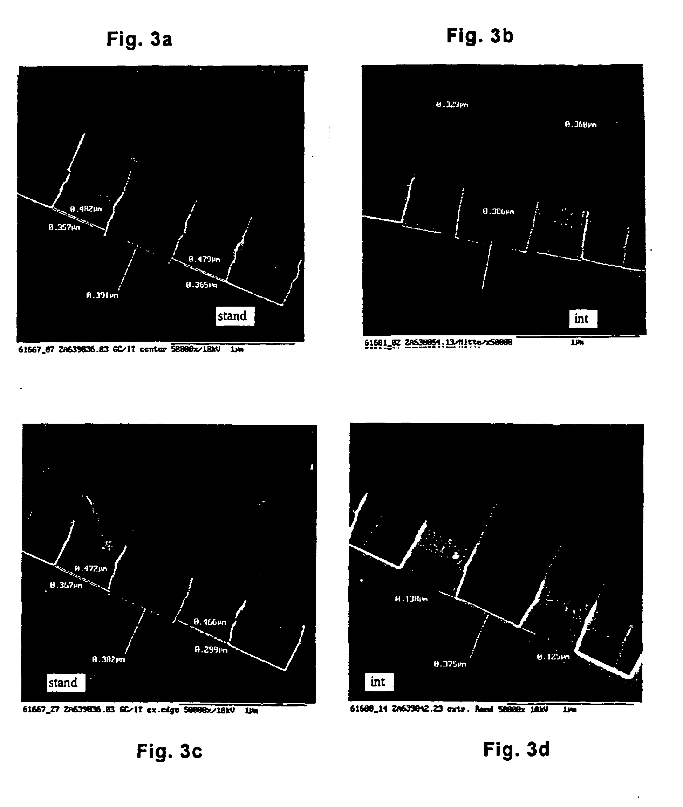

Fig. 3 gibt einen Vergleich von Wortleitungen, die gemäß dem Strukturierungsverfahren einerseits und einem zweistufigen Standardätzverfahren andererseits strukturiert wurden. Fig. 3a und 3b zeigen Wortleitungen im Bereich der Wafermitte, Fig. 3c und 3d solche am extremen Waferrand. Die nach dem Standardätzverfahren hergestellten Wortleitungen sind in Fig. 3a und 3c gezeigt.

Die so hergestellten Wortleitungen fallen durch ein Unterätzen (Undercut) im Wolframsilicid sowie asymmetrische Flanken auf. Letzteres Merkmal ist besonders in Fig. 3c zu bemerken, was unter anderem davon herrührt, daß die Halterung des Wafers während des Ätzens mit einem Klammerring erfolgte. Derartige asymmetrische Flanken können im Extremfall zu Kurzschlüssen zwischen Gate Conductor (GC) und Deep Trench (DT) führen.

Derartige GC/DT-Kurzschlüsse treten bei den mit Hilfe des erfindungsgemäßen Verfahrens geätzten Wortleitungen nicht auf. Undercuts werden nicht beobachtet, und es werden symmetrische Flanken erhalten, wie Fig. 3b und 3d zu entnehmen ist.
Tabelle 3 verdeutlicht die Ergebnisse anhand der GC/DT-Werte für einige ausgewählte Halbleiterwafer. Die ersten fünf Werte beziehen sich auf das beschriebene Strukturierungsverfahren, die restlichen auf das Standardverfahren. Die Meßwerte zeigen eindeutig, daß sogenannte harte Fehler durch Kurzschlüsse zwischen Gate Conductor (GC) und Deep Trench (DT) beim beschriebenen Verfahren nicht auftreten (1 = 100 % fehlerfrei), während die Fehlerquote beim Standardverfahren bei durchschnittlich 97 % liegt. Der Grund für die verbesserten Ergebnisse durch das beschriebene Strukturierungsverfahren liegen in der Herstellung gerade geätzter Flanken und einer verbesserten Überätzung, bei der das Polysilicium mit hoher Selektivität und Homogenität über die gesamte Waferfläche in den gewünschten Bereichen vollständig entfernt wird. Besonders gute Ergebnisse lassen sich erzielen, wenn der Wafer während des Ätzvorgangs elektrostatisch gehalten wird.

**Tabelle 3**

| Wafer / Gruppe / Los | | GC/DT |
|---|---|---|
| | Erfindung/Standard | |
| 2 | Erfindung | 1 |
| 6 | -"- | 1 |
| 10 | -"- | 1 |
| 16 | -"- | 1 |
| 20 | -"- | 1 |
| 1 | Standard | 0,963 |
| 5 | -"- | 0,981 |
| 11 | -"- | 0,963 |
| 15 | -"- | 0,945 |
| 21 | -"- | 0,981 |
| 23 | -"- | 0,972 |
| 25 | -"- | 0,963 |

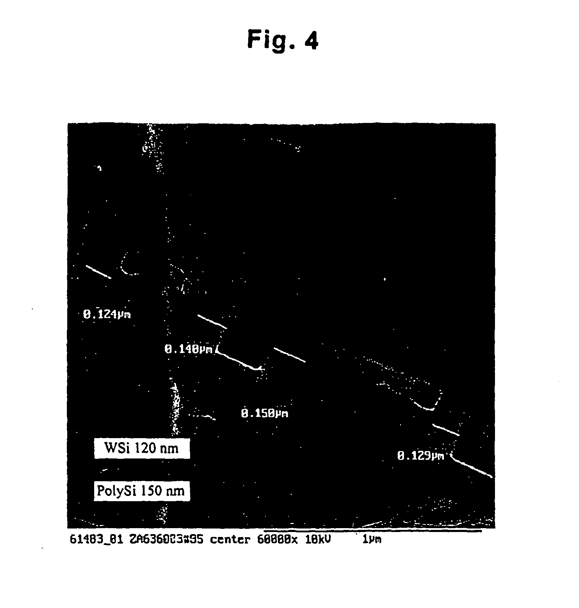

Fig. 4 verdeutlicht, daß das Strukturierungsverfahren selbst dann angewendet werden kann, wenn die Schichtdicke der jeweiligen Schichten in der Schichtstruktur verringert ist. Gegenüber den im Standardverfahren üblichen Schichtdicken von 200 nm für das Polysilicium und 170 nm für Wolframsilicid sind in der gezeigten Schichtstruktur die Schichtdicken auf 120 nm für das Wolframsilicid und 150 nm für das Polysilicium reduziert. Insgesamt kann damit die Schichtdicke der Schichtstruktur um 100 nm gegenüber den üblicherweise verwendeten Schichtstrukturen verringert werden, ohne daß damit Qualitätseinbußen verbunden wären. Beim Auffüllen der Schichtstruktur mit weiteren Schichten oder Metallisierungsebenen steht daher ein erheblich größerer Spielraum als bisher zur Verfügung.

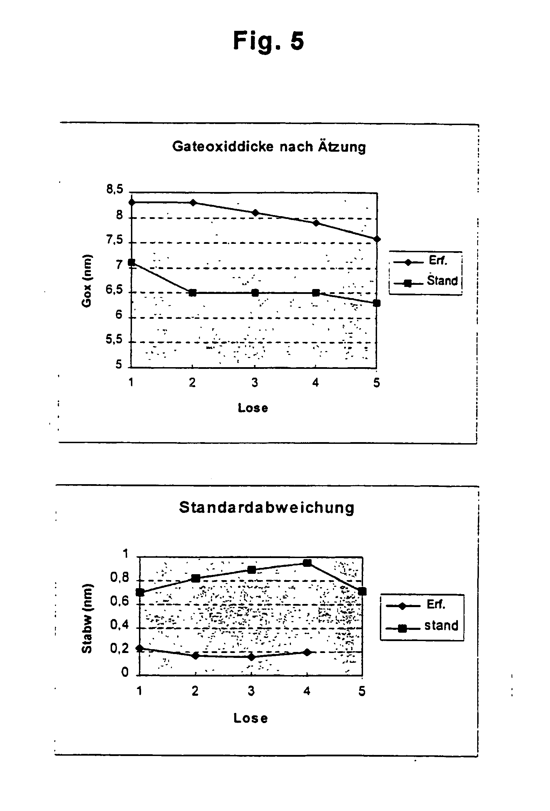

Fig. 5a zeigt die Dicke der Gateoxidschicht (Gox), welche unter der Polysiliciumschicht in der zu strukturierenden Schichtstruktur angeordnet ist, nach dem Ätzen gemäß dem zweistufigen Standardverfahren und dem Strukturierungsverfahren. Fig. 5b gibt die den Ergebnissen von Fig. 5a zugehörigen Standardabweichungen an. Fig. 5a belegt, daß das Gateoxid durch das Strukturierungsverfahren weit weniger angegriffen wird als durch das Standardverfahren. Die Dicke des Gateoxids ist nach dem Strukturierungsverfahren etwa 1 nm größer als bei herkömmlicher Strukturierung. Dies bedeutet, daß das nach dem Verfahren erhaltene Produkt deutlich weniger anfällig gegen Leckströme ist, die bei zu dünner Gateoxidschicht entstehen können. Die elektrischen Eigenschaften des Chips können insgesamt verbessert werden. Als Folge der sehr selektiven Ätzung durch das Verfahren ist es daher möglich, die Dicke der Gateoxidschicht zu verringern und so die Gesamthöhe der zu strukturierenden Schichtstruktur weiter zu vermindern.

### Beispiel 3

### Endpunktbestimmung mittels optischer Emissionsspektroskopie

Die Endpunktbestimmung für das in Beispiel 2 beschriebene Ätzverfahren soll nachfolgend am Beispiel der Mainetch- und Overetch-Schritte näher erläutert werden.

Grundsätzlich beruht die optische Emissionsspektroskopie (OES) darauf, daß die Emission einer Ätzverbindung oder eines der Ätzprodukte über den Verlauf des Ätzschrittes beobachtet wird. Die Emission der ausgewählten Verbindung ist proportional ihrer Konzentration, welche wiederum Aufschluß über den Fortschritt des Ätzvorgangs bietet.

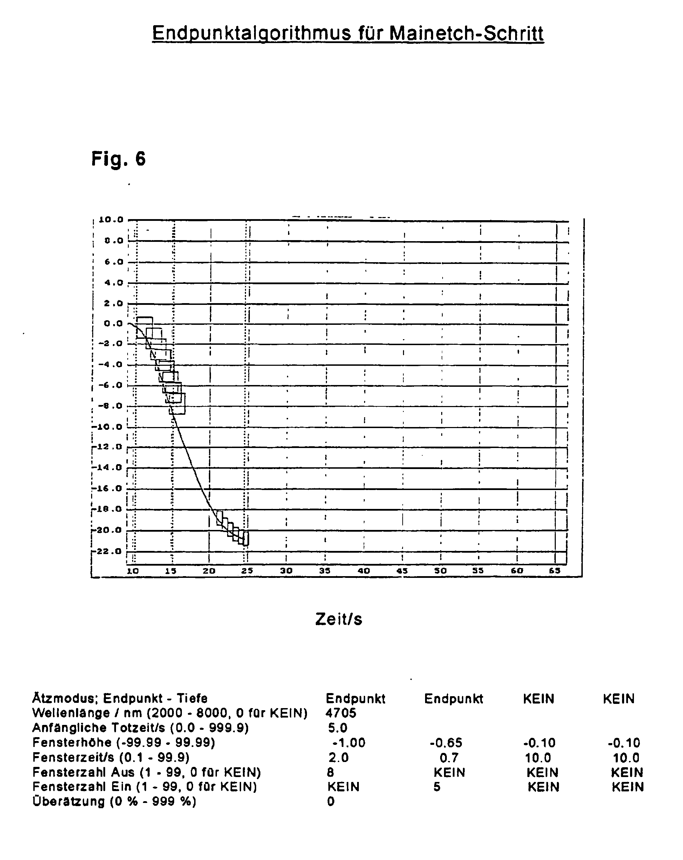

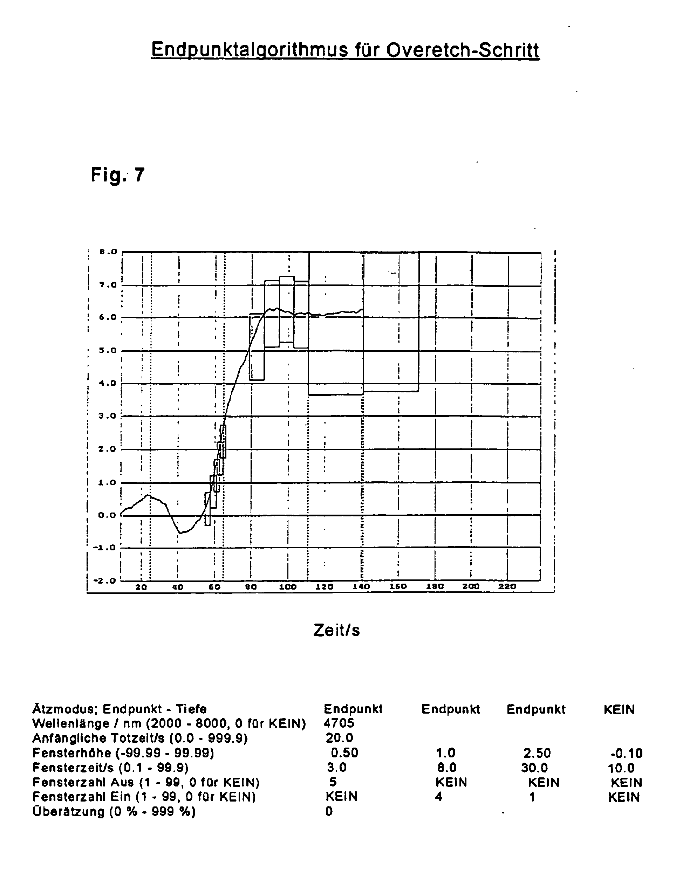

Die Vorrichtung zur Bestimmung der optischen Emission kann grundsätzlich den üblicherweise zu diesem Zweck verwendeten Vorrichtungen entsprechen. Vorzugsweise wird das emittierte Licht aus der Ätzkammer über ein Fenster in der Kammer mit Hilfe einer Lichtleitfaser auf einen Monochromator geleitet. Dann wird das emittierte Licht bei einer für den zu detektierenden Stoff charakteristischen Wellenlänge mit einem geeigneten Spektrometer gemessen. Das im Verlauf des Ätzvorgangs emittierte Spektrum wird mit einem für den jeweiligen Ätzvorgang vorgegebenen Algorithmus verglichen. Bei Erreichen des vorgegebenen Endpunkts wird der Ätzvorgang beendet. Fig. 6 und 7 zeigen beispielhaft zwei Endpunktalgorithmen für den Mainetch- bzw. den Overetch-Schritt.

### a) Endpunktbestimmung für den Mainetch-Schritt

Im Mainetch-Schritt wird, wie vorstehend beschrieben, ein Großteil der Polysiliciumschicht geätzt. In der in Beispiel 2 beschriebenen Schichtstruktur handelt es sich bei der Polysiliciumschicht um eine Wolfram-dotierte Schicht. Als Ätzmittel dient ein chlorhaltiges Ätzgas.

Bei diesem Ätzschritt ist es entscheidend, daß ein Rest der Polysiliciumschicht nicht geätzt wird. Würde keine Restschicht erhalten bleiben, die in einem anschließenden Ätzschritt mit bromhaltigem Ätzgas weggeätzt wird, wäre nicht zu verhindern, daß das Gateoxid angegriffen wird.

Würde zur Endpunktbestimmung im Mainetch-Schritt wie üblich die Interferenzmessung eingesetzt, könnte nur das vollständige Wegätzen der Polysiliciumschicht festgestellt werden. Die verwendete OES ermöglicht es dagegen, den Endpunkt so zu bestimmen, daß ein Rest der Polysiliciumschicht erhalten bleibt. OES-Spektren für das Mainetch-Verfahren weisen nämlich grundsätzlich einen gekrümmten Verlauf auf, mit einer Abflachung bei geringer Restschichtdicke. Der Endpunkt wird so festgelegt, daß er in den Bereich dieser Kurvenabflachung fällt.

Im konkreten Fall wurde die optische Emission des Dotierstoffes Wolfram bei 4705 nm bestimmt. Das in das Polysilicium implantierte Wolfram wird im Hauptätzschritt gemeinsam mit dem Polysilicium geätzt und gelangt so in die Gasphase in der Ätzkammer. Im Verlauf des Hauptätzschrittes nimmt die Konzentration des Wolframs stetig ab, und entsprechend wird die für das Wolfram gemessene Emission geringer. Der Endpunktalgorithmus, der in Fig. 6 wiedergegeben ist, wurde entsprechend diesem Verlauf definiert. Dabei ist auf der y-Achse eine der Lichtintensität proportionale Meßgröße und auf der x-Achse die Zeit in Sekunden aufgetragen.

Im einzelnen wurden zu Beginn der Kurve acht Fenster mit einer 1 virtuellen Einheit entsprechenden Höhe und einer Breite von 2 Sekunden definiert. Der Endpunkt des Ätzvorgangs wurde durch fünf Fenster von 0,65 virtuellen Einheiten Höhe und 0,7 Sekunden Breite definiert, die so festgelegt wurden, daß das Polysilicium mit einer Restschichtdicke von 50 nm erhalten bleibt. Andere Restschichtdicken können durch geeignete Festlegung der Fenster leicht eingestellt werden.

Während des Ätzvorgangs wird der tatsächliche Verlauf des gemessenen Emissionsspektrums mit dem Algorithmus verglichen, und der Ätzvorgang wird abgebrochen, wenn das letzte der fünf beschriebenen Fenster im abgeflachten Kurvenstück durchlaufen ist. Auf diese Weise ist ein definierter Stopp des Mainetch-Schrittes bei einer vorher festgelegten Restschichtdicke möglich.

### b) Endpunktbestimmung für den Overetch-Schritt

Wie in Beispiel 2 beschrieben, wird die Restschicht des im Mainetch-Schritt nicht weggeätzten Polysiliciums mit einem bromhaltigen Ätzgas entfernt.

Die Endpunktbestimmung mittels OES erfolgt grundsätzlich wie vorher beschrieben. Als Meßgröße dient hier die durch das Ätzmittel Bromwasserstoff hervorgerufene Emission. Auch hier liegt die zu messende Wellenlänge (zufällig) bei 4705 nm. Da im Overetch-Schritt kein Wolfram mehr vorhanden ist, tritt hierdurch aber keine Verfälschung der Ergebnisse auf.

Der Kurvenverlauf im Overetch-Schritt ist anders als im Mainetch-Schritt. Solange noch Polysilicium-Restschicht vorhanden ist, wird Bromwasserstoff beim Ätzen verbraucht. Seine Konzentration im Gas ist daher vergleichsweise gering. Mit zunehmender Dauer des Ätzschrittes nimmt der Verbrauch an HBr jedoch ab, die Konzentration des Bromwasserstoffes in der Gasphase und seine Emission also zu. Ist das Polysilicium vollständig weggeätzt, bleibt die Konzentration des Bromwasserstoffs auf hohem Niveau konstant. Der Endpunkt des Overetch-Schrittes wird in diesen abgeflachten Kurvenbereich gelegt.

Fig. 7 zeigt einen entsprechenden Endpunktalgorithmus. Die Einheiten von x- und y-Achse entsprechen denjenigen aus Fig. 6. Der Kurvenverlauf ist im gezeigten Fall durch fünf Fenster im ansteigenden Bereich der Kurve und vier plus ein Fenster im abgeflachten Endbereich definiert.
Lage und Größe der Fenster können auf an sich bekannte Weise anhand einiger Testdurchläufe festgelegt werden. Auf die gezeigte Weise kann der Overetch-Schritt auf dem Gateoxid gestoppt und so eine Beschädigung des Gateoxids durch das Ätzmittel vermieden werden.

## Patentansprüche

1. Verfahren zur Herstellung einer dotierten Schicht, die polykristallines Silicium aufweist, umfassend folgende Schritte:
- Abscheiden von dotiertem polykristallinem Silicium mittels einer chemischen Gasphasenabscheidung unter Vakuum, indem eine Dotierverbindung als Prozeßgas bei der chemischen Gasphasenabscheidung zugesetzt wird,
- Beenden der Zufuhr der Dotierverbindung zum Prozessgas nach dem Erreichen der gewünschten Dotierung und der gewünschten Abscheidedauer, so daß eine Schicht aus undotiertem Silicium als Grenzschicht der dotierten Siliciumschicht während der chemischen Gasphasenabscheidung unter Vakuum abgeschieden wird,
- anschließend Abscheiden einer weiteren Schicht aus Metall oder Metallsilicid auf der auf der dotierten Polysiliciumschicht befindlichen Silicium-Grenzschicht unter Verwendung einer chemischen Gasphasenabscheidung unter Vakuum, wobei
- das Vakuum zwischen der Abscheidung der dotierten Polysiliciumschicht und der Abscheidung der Metall- oder Metallsilicidschicht nicht aufgehoben wird.

2. Verfahren gemäß Anspruch 1,
**dadurch gekennzeichnet ,**
**daß** als Dotierverbindung eine gasförmige oder leichtflüchtige Verbindung des Bors, Galliums, Indiums, Phosphors, Arsens oder Antimons verwendet wird.

3. Verfahren gemäß Anspruch 2,
**dadurch gekennzeichnet ,**
**daß** als Dotierverbindung Diboran (B₂H₆), Trimethylbor (B(CH₃)₃), Phosphan (PH₃) oder Arsan (AsH₃) verwendet wird.

4. Verfahren gemäß einem der Ansprüche 1 bis 3,
**dadurch gekennzeichnet ,**
**daß** die Konzentration der Dotierverbindung, bezogen auf die Gesamtkonzentration der abzuscheidenden Verbindungen, im Verlauf der Gasphasenabscheidung gesteigert wird.

5. Verfahren gemäß einem der Ansprüche 1 bis 4,
**dadurch gekennzeichnet ,**
**daß** die Konzentration der Dotierverbindung, bezogen auf die Gesamtkonzentration der abzuscheidenden Verbindungen, im Verlauf der Gasphasenabscheidung verringert wird.

6. Verfahren gemäß einem der Ansprüche 1 bis 5,
**dadurch gekennzeichnet ,**
**daß** die Konzentration der Dotierverbindung, bezogen auf die Gesamtkonzentration der abzuscheidenden Verbindungen, im Verlauf der Gasphasenabscheidung konstant gehalten und die Gesamtkonzentration der abzuscheidenden Verbindungen im Verlauf der Abscheidung gesteigert wird.

7. Verfahren gemäß einem der Ansprüche 1 bis 6,
**dadurch gekennzeichnet ,**
**daß** die dotierte Polysiliciumschicht auf eine Gateoxidschicht abgeschieden wird.

8. Verfahren gemäß einem der Ansprüche 4 bis 7,
**dadurch gekennzeichnet ,**
**daß** zunächst reines Silicium abgeschieden und anschließend
mit der Zufuhr der Dotierverbindung begonnen wird.

9. Verfahren gemäß einem der Ansprüche 1 bis 8,
**dadurch gekennzeichnet ,**
**daß** als Metallsilicid ein Silicid des Cobalts, Titans, Tantals, Molybdäns oder Wolframs abgeschieden wird.

10. Verfahren gemäß einem der Ansprüche 1 bis 9,
**dadurch gekennzeichnet ,**
**daß** die Abscheidung der Metall- oder Metallsilicidschicht in einer anderen Kammer der Vorrichtung zur chemischen Gasphasenabscheidung erfolgt, die zur Herstellung der dotierten Polysiliciumschicht verwendet wird.

11. Verfahren gemäß einem der Ansprüche 9 oder 10,
**dadurch gekennzeichnet ,**
**daß** auf Metall- oder Metallsilicidschicht eine Isolationsschicht, insbesondere eine Isolationsschicht aus Siliciumdioxid aufgebracht wird.

12. Verfahren gemäß einem der Ansprüche 1 bis 3,
**dadurch gekennzeichnet ,**
**daß** die Konzentration der Dotierverbindung kontinuierlich oder schrittweise erhöht wird, bis die gewünschte Konzentration an Dotieratomen im Polysilicium erreicht wird.

13. Verfahren gemäß einem der Ansprüche 1 bis 3,
**dadurch gekennzeichnet ,**
**daß** zunächst reines Silizium abschieden wird und anschließend die Konzentration der Dotierverbindung kontinuierlich oder schrittweise erhöht wird, bis die gewünschte Konzentration an Dotieratomen im Polysilicium erreicht wird.

## Claims

1. Method for producing a doped layer comprising polycrystalline silicon, comprising the following steps:
- depositing doped polycrystalline silicon by means of a chemical vapour deposition under a vacuum by adding a doping compound as a process gas during the chemical vapour deposition,
- ending the feeding of the doping compound to the process gas after attaining the desired doping and the desired deposition duration, such that a layer composed of undoped silicon is deposited as a boundary layer of the doped silicon layer during the chemical vapour deposition under a vacuum,
- subsequently depositing a further layer composed of metal or metal silicide on the silicon boundary layer situated on the doped polysilicon layer, using a chemical vapour deposition under a vacuum, wherein
- the vacuum is not eliminated between the deposition of the doped polysilicon layer and the deposition of the metal or metal silicide layer.

2. Method according to Claim 1,
**characterized**
**in that** the doping compound used is a gaseous or readily volatile compound of boron, gallium, indium, phosphorus, arsenic or antimony.

3. Method according to Claim 2,
**characterized**
**in that** the doping compound used is diborane (B₂H₆), trimethylboron (B(CH₃)₃), phosphane (PH₃) or arsane (AsH₃).

4. Method according to any of Claims 1 to 3, **characterized**
**in that** the concentration of the doping compound, relative to the total concentration of the compounds to be deposited, is increased in the course of the vapour deposition.

5. Method according to any of Claims 1 to 4, **characterized**
**in that** the concentration of the doping compound, relative to the total concentration of the compounds to be deposited, is decreased in the course of the vapour deposition.

6. Method according to any of Claims 1 to 5, **characterized**
**in that** the concentration of the doping compound, relative to the total concentration of the compounds to be deposited, is kept constant in the course of the vapour deposition and the total concentration of the compounds to be deposited is increased in the course of the deposition.

7. Method according to any of Claims 1 to 6, **characterized**
**in that** the doped polysilicon layer is deposited onto the gate oxide layer.

8. Method according to any of Claims 4 to 7, **characterized**
**in that** firstly pure silicon is deposited and subsequently the feeding of the doping compound is begun.

9. Method according to any of Claims 1 to 8, **characterized**
**in that** a silicide of cobalt, titanium, tantalum, molybdenum or tungsten is deposited as metal silicide.

10. Method according to any of Claims 1 to 9, **characterized**
**in that** the deposition of the metal or metal silicide layer takes place in a different chamber of the device for chemical vapour deposition which is used for producing the doped polysilicon layer.

11. Method according to either of Claims 9 and 10,
**characterized**
**in that** an insulation layer, in particular an insulation layer composed of silicon dioxide, is applied to the metal or metal silicide layer.

12. Method according to any of Claims 1 to 3,
**characterized**
**in that** the concentration of the doping compound is increased continuously or in steps until the desired concentration of doping atoms in the polysilicon is attained.

13. Method according to any of Claims 1 to 3,
**characterized**
**in that** firstly pure silicon is deposited and subsequently the concentration of the doping compound is increased continuously or in steps until the desired concentration of doping atoms in the polysilicon is attained.

## Revendications

1. Procédé de production d'une couche dopée, qui a du silicium polycristallin, comprenant des stades suivants :
- on dépose du silicium polycristallin dopé au moyen d'un dépôt chimique en phase gazeuse sous vide, en ajoutant un composé de dopage en tant que gaz de processus lors du dépôt chimique en phase gazeuse,
- on met fin à l'apport du composé de dopage au gaz de processus après que le dopage souhaité et la durée de dépôt souhaitée ont été atteints, de manière à déposer une couche de silicium non dopé comme couche limite de la couche de silicium dopé pendant le dépôt chimique en phase gazeuse sous vide,
- on dépose ensuite une autre couche en métal ou en siliciure métallique sur la couche limite de silicium se trouvant sur la couche de polysilicium dopé en utilisant un dépôt chimique en phase gazeuse sous vide, dans lequel,
- on ne supprime pas le vide entre le dépôt de la couche en polysilicium dopé et le dépôt de la couche métallique ou en siliciure métallique.

2. Procédé suivant la revendication 1,
**caractérisé en ce que**
l'on utilise comme composé de dopage un composé gazeux ou très volatil, du bore, du gallium, de l'indium, du phosphore, de l'arsenic ou de l'antimoine.

3. Procédé suivant la revendication 2,
**caractérisé en ce que**
l'on utilise comme composé de dopage le diborane ( B₂H₆ ) , le triméthylbore ( B ( CH₃ )₃ ), le phosphane ( PH₃ ) ou l'arsane ( AsH₃ ) .

4. Procédé suivant l'une des revendications 1 à 3,
**caractérisé en ce que**
l'on augmente la concentration du composé de dopage, rapportée à la concentration totale des composés à déposer, au cours du dépôt en phase gazeuse.

5. Procédé suivant l'une des revendications 1 à 4,
**caractérisé en ce que**
l'on diminue la concentration du composé de dopage, rapportée à la concentration totale des composés à déposer, au cours du dépôt en phase gazeuse.

6. Procédé suivant l'une des revendications 1 à 5,
**caractérisé en ce que**
l'on tient constante la concentration du composé de dopage, rapportée à la concentration totale des composés à déposer, au cours du dépôt en phase gazeuse et on augmente la concentration totale des composés à déposer au cours du dépôt.

7. Procédé suivant l'une des revendications 1 à 6,
**caractérisé en ce que**
l'on dépose la couche de polysilicium dopé sur une couche d'oxyde de grille.

8. Procédé suivant l'une des revendications 4 à 7,
**caractérisé en ce que**
l'on dépose d'abord du silicium pur et on commence ensuite l'apport du composé dopé.

9. Procédé suivant l'une des revendications 1 à 8,
**caractérisé en ce que**
l'on dépose comme siliciure métallique un siliciure du cobalt, du titane, du tantale, du molybdène ou du tungstène.

10. Procédé suivant l'une des revendications 1 à 9,
**caractérisé en ce que**
l'on effectue le dépôt de la couche de métal ou de siliciure métallique dans une autre chambre du dispositif pour le dépôt chimique en phase gazeuse que celle qui est utilisée pour la production de la couche de polysilicium dopé.

11. Procédé suivant l'une des revendications 9 ou 10,
**caractérisé en ce que**
l'on dépose sur la couche métallique ou en siliciure métallique une couche isolante, notamment une couche isolante en dioxyde de silicium.

12. Procédé suivant l'une des revendications 1 à 3,
**caractérisé en ce que**
l'on augmente en continu ou pas à pas la concentration du composé de dopage jusqu'à obtention de la concentration souhaitée en atomes de dopage du polysilicium.

13. Procédé suivant l'une des revendications 1 à 3,
**caractérisé en ce que**
l'on dépose d'abord du silicium pur et on augmente ensuite en continu ou pas à pas la concentration du composé de dopage jusqu'à obtention de la concentration souhaitée en atomes de dopage du polysilicium.
